# EUROPEAN PATENT APPLICATION

(11) **EP 4 459 851 A1**
(43) Date of publication of application: **06.11.2024**
(21) Application number: 24173778.2
(22) Date of filing: 02.05.2024
(51) Int. Cl.: H02K 9/22, H02K 11/33

(54) **ELECTRIC MOTOR WITH HEAT DISSIPATION SYSTEM**

(30) Priority: 03.05.2023 IT 202300008649
(71) Applicant: TACO ITALIA S.r.l., 36066 Sandrigo (VI) (IT)
(72) Inventor: PERUZZO, Fabio, 36100 Vicenza (IT); MANFRIN, Federico, 36031 Dueville (VI) (IT)
(74) Representative: Botti & Ferrari S.p.A.

(57) **Abstract**

Electric motor with heat dissipation system. The electric motor (100) comprises: an electric motor body (110); at least one electronic board (300) for power supply and control of the electric motor (100), the at least one electronic board (300) comprising at least one power module (301); a housing portion (200; 201, 202) associated with the electric motor body (110) to contain the at least one electronic board (300). The heat dissipation system comprises: at least one flat metal element (302) on at least one surface of the at least one electronic board (300) adjacent to the at least one power module (301); a dissipation surface (211; 212) of the housing portion (200; 201, 202), the dissipation surface (211, 212) being made of plastic; a compression-yielding element (401; 402) in thermal contact between the at least one flat metal element (302) and the dissipation surface (211; 212). In particular, the electric motor (100) is part of a fluid circulator (10).

## Description

### Technical field

The present invention relates to an electric motor with heat dissipation system.

In general, the present invention can be applied in the field of electric motors with control electronic boards, which comprise power modules generating heat.

### Prior art

In general, the control electronic boards associated with the electric motors generate heat, in particular heat associated with the functioning of power modules. It is necessary to dissipate such heat for the correct operation of the electric motor and of the electronic board.

For this purpose, the association of a metal heat sink with electric motors is known, the heat sink being typically made of aluminum and exposed to the environment in which heat has to be dissipated by means of mainly convective transfer. However, a solution with a metal heat sink requires electric grounding, which is not always easily achievable, and requires specific features to comply with regulations (for example, for distances, insulations, etc.). Therefore, solutions with metal heat sink have considerable costs and sizes.

The document EP3418580 (A1) relates to a fluid circulator comprising a pump body and an electric motor body, as well as an end portion associated with the electric motor body for an electronic board. At least one portion of a closure wall, the portion being lowered toward the electronic board and externally provided with cooling fins to form the heat sink, is provided; a layer of a good heat conductive material is provided in contact between the electronic power devices and the lowered surface.

The document EP2166230 (A1) relates to a pump unit provided with an electric-motor housing; a cover made of thermally conductive plastic covers the electric-motor housing and is in contact with an electronic component, for example a printed circuit, on an inner side, where the electronic component produces thermal dispersions.

The document EP 1701431 (A1) relates to a terminal box with a plastic housing in which a heat-producing component is arranged; cover sections are made of a thermally conductive material, such as highly thermally conductive plastic or metal; heat-producing components are covered in the upper part by a thermally conductive cushion.

The document US2010301690 (A1) relates to an electric machine comprising an electric motor and a power-supply electronic circuit; a heat sink is made in the cover.

The document EP 1582751 (A1) relates to a pump assembly with an electric motor and a heat distributor for cooling electronic components.

A technical problem underlying the present invention is to provide a heat dissipation system for an electric motor.

An object of the present invention is to provide an effective dissipation of the heat generated by power modules of an electronic board.

A further object of the present invention is to provide an effective heat dissipation from a housing portion associated to an electric motor.

A further object of the present invention is to provide an electric motor with heat dissipation system that is compact and has small size.

A further object of the present invention is to provide an electric motor with heat dissipation system that is more effective than the prior art.

### Summary of the invention

A solution idea underlying the present invention is to provide a heat dissipation system which is suited to the one or more power modules of a control electronic board of the electric motor.

Heat transfer localized at the generation point of the power module is provided, to distribute said heat on a larger surface consisting of at least one flat metal element, which may cover up to 30%, or even more, of the total surface of a printed circuit of the electronic board (PCB).

An adequate increase of the thickness of copper of the printed circuit is provided, thereby creating the at least one flat metal element.

The use of materials to convey heat is also provided, the heat being spread on a larger surface to be exchanged by convection with the surrounding environment.

A distributed heat dissipation system is provided, which involves a cooperation of three distinct elements: the generated heat flows from the power module to the flat metal portion of the electronic board, then a compression-yielding element collects it from the electronic board and brings it to the housing portion which has a dissipation surface made of plastic which in turn spreads it to the environment.

Based on said solution idea, the technical problem is solved by an electric motor with heat dissipation system.

The electric motor comprises an electric motor body and at least one electronic board for power supply and control of the electric motor. The at least one electronic board comprises at least one power module.

The electric motor comprises a housing portion, such as a terminal box or the like, associated with the electric motor body to contain the at least one electronic board.

The heat dissipation system comprises at least one flat metal element on at least one surface of the at least one electronic board adjacent to the at least one power module.

The heat dissipation system further comprises a dissipation surface of the housing portion. The dissipation surface is made of plastic.

The heat dissipation system comprises a compression-yielding element in thermal contact between the at least one flat metal element and the dissipation surface.

Advantageously, the at least one flat metal element allows distribution of the heat generated by the at least one power module on a larger surface.

Advantageously, the compression-yielding element allows a better conductive thermal contact with the flat metal element, for heat removal. In particular, "compression-yielding" means the capability of a material to deform and fill a gap, to provide a localized thermal contact.

Advantageously, the compression-yielding element allows to dissipate heat mainly by conduction, preventing in-between air that would negatively affect heat exchange.

Advantageously, the dissipation surface with which the compression-yielding material is thermally coupled, said material being preferably co-manufactured i.e. by injection coating, allows an effective heat conduction toward the dissipation surface made of plastic, which in turn will allow heat dissipation toward the outside, by convection.

Advantageously, the present invention allows to convey the generated heat onto large metal areas, in particular made of copper, suitably sized, of the at least one metal element, said metal areas being provided as an integral part of the heat dissipation system and preferably obtained on the two sides of the electronic board.

Advantageously, the thickness of the at least one metal element is maximized to be able to accumulate as much heat as possible, effectively extracting it from the power module which generates the heat.

Advantageously, several power modules may be used, said power modules being no longer monolithic, but rather distributed, configured for spreading heat in several metal elements of the electronic board, preferably on both faces.

Advantageously, the invention provides large heat-spreading areas, and it is possible to use as heat conductive carriers electrically insulating materials too, therefore no longer metals but rubbers/plastics, to let the heat flow toward the environment and to dissipate it.

Further features and advantages will become clearer from the detailed description given herein below of one preferred non-limiting embodiment of the present invention, and from the dependent claims that outline preferred and particularly advantageous embodiments of the invention.

### Brief description of the drawings

The invention is illustrated with reference to the following figures, which are provided by way of non-limiting example, where:
- Figure 1 shows a side view of a fluid circulator comprising an electric motor.
- Figure 2 shows a sectional view of the fluid circulator of Figure 1.
- Figure 3 shows a disassembled perspective view of the fluid circulator of Figure 1.
- Figure 4 shows a first embodiment of a heat dissipation system.
- Figure 5 shows an embodiment of flat metal elements.
- Figures 6A and 6B show two faces of an electronic board comprising flat metal elements.
- Figure 7 shows an embodiment of a first dissipation surface.
- Figure 8 shows an embodiment of a second dissipation surface.
- Figures 9A and 9B show sectional views of the heat dissipation system of Figure 4.
- Figures 10A and 10B show the temperature distribution on an embodiment of electronic board.
- Figure 11 shows a detail of the coupling of a compression-yielding element with a cover of a housing portion.
- Figure 12 schematically shows an apparatus for over-molding a thermoplastic elastomer on a flat, plastic dissipation surface.
- Figures 13A and 13B show a variant of the heat dissipation system comprising a thermal conductive insert.
- Figure 14 shows a second embodiment of a heat dissipation system.
- Figure 15 shows a third embodiment of a heat dissipation system.

In the different figures, analogous elements will be identified by analogous reference numerals.

If one figure contains a plurality of analogous elements, it is possible that only one or some of them are actually indicated by respective reference numerals for the sake of graphic clarity, construing that also the others are included by analogy.

### Detailed description

Centrifugal motor pumps, generally known under the name of "fluid circulators" or simply "circulators", are used for the circulation of a carrier fluid in the context of heating and/or cooling systems.

As it is known, a circulator generally comprises an electric motor, coupled with an impeller of a pump which is thus operated by said electric motor and which provides head to the fluid.

Therefore, for the following description of the electric motor with heat dissipation system, reference will generally be made to the non-limiting example of a circulator.

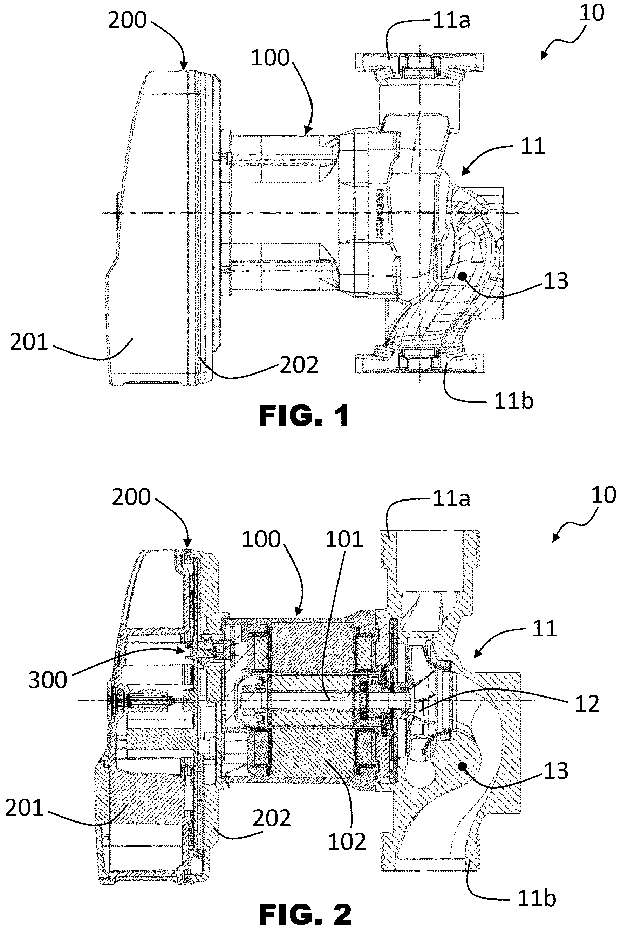

Figure 1 shows a side view of a fluid circulator 10 comprising an electric motor 100 representing a non-limiting example of the present invention.

Figure 2 shows an analogous sectional side view of the fluid circulator 10, wherein the inner components thereof are better visible.

In its general configuration, the circulator 10 comprises a pump body 11 and an electric motor 100, associated with each other to give fluid movement.

The pump body 11 comprises inside itself an impeller 12 connected to and put in rotation by the electric motor 100. In general, the impeller 12 is enclosed in a containing volute 13, which contains the fluid during circulator operation.

The pump body 11 comprises an outlet connection 11a and an inlet connection 11b, for fluid connection to a pipe system, to which the fluid circulator 10 is connected and inside which the fluid to be moved flows.

The electric motor 100, which is preferably of the synchronous type, is essentially comparable in the following components thereof that are visible in Figure 2: a permanent-magnet rotor 101 and a stator 102 with the related electrical winding.

In general, the electric motor 100 and the pump body 11 are separated from each other by a plurality of suitable sealing separation elements, so as to make an impermeable motor body and a fluid-tight volute, preventing fluid leak.

The fluid circulator 10 further comprises a terminal box 200 preferably associated with an end of the electric motor 100, in particular opposite the pump body 11. The terminal box 200 comprises a cover 201 for closing and protecting an electronic board 300 for the control of the fluid circulator 10.

The electronic board 300 is designated for the control of the operation of the fluid circulator 10, in particular for the control of the power supply of the electric motor 100.

The control electronic board 300 is housed in a housing portion defined and delimited by the cover 201 when the same is fitted and mounted on the counterpart 202 of the terminal box 200.

Thus, the terminal box 200 represents a non-limiting example of a housing portion connected to the body of the electric motor 100. In general, other solutions are possible for different portions for housing at least one electronic board of the electric motor, as it will be generalized below in connection with the description of the heat dissipation system.

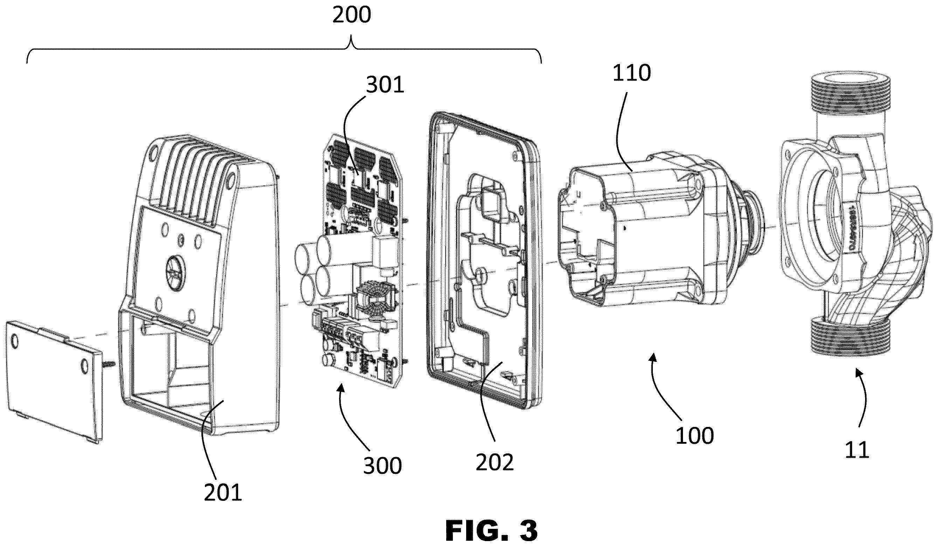

Figure 3 shows a disassembled perspective view of the already described fluid circulator 10.

With reference to the electric motor 100, it comprises the electric motor body 110 and at least one electronic board 300 (in the example there is only one, but there could be more) for power supply and control of the electric motor 100.

The electric motor 100 comprises also the housing portion 200 associated with the electric motor body 101 to contain the at least one electronic board 300. As it will be further described, the at least one electronic board 300 comprises at least one power module 301.

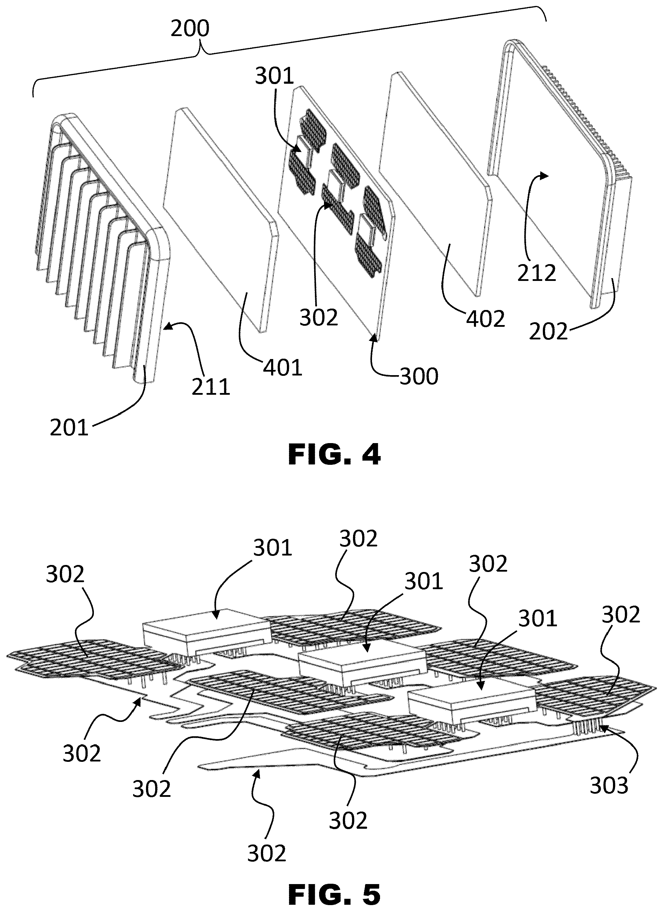

Figure 4 shows a first embodiment of a heat dissipation system, associated with the housing portion 200. In this embodiment, the housing portion 200 represents a simplification of the previously described terminal box 200.

The heat dissipation system comprises at least one flat metal element 302 on at least one surface of the at least one electronic board 300, adjacent to the at least one power module 301. In this example, there are multiple flat metal elements 302 associated with and adjacent to respective three power modules 301.

The heat dissipation system further comprises a dissipation surface 211 of the housing portion 200 at the element 201. The dissipation surface 211 is made of plastic, just as the element 201.

The heat dissipation system further comprises a compression-yielding element 401 in thermal contact between the at least one flat metal element 302 and the dissipation surface 211, as it will be further described.

The at least one flat metal element 302 also extends, as it will be better described below, on the opposite surface of the at least one electronic board 300, still adjacent to the at least one power module 301 but on the opposite face.

Thus, the heat dissipation system comprises a dissipation surface 212 of the housing portion 200 at the element 202. The dissipation surface 212 is made of plastic, just as the element 202.

The heat dissipation system further comprises a compression-yielding element 402 in thermal contact between the at least one flat metal element 302 and the dissipation surface 212, as it will be further described.

It is thus to be understood that heat dissipation occurs on both sides of the at least one electronic board 300, by means of a replication of the compression-yielding elements 401 and 402 which provide thermal contact between the at least one flat metal element 302 (on the two sides of the electronic board 300) and the respective dissipation surfaces 211 and 212.

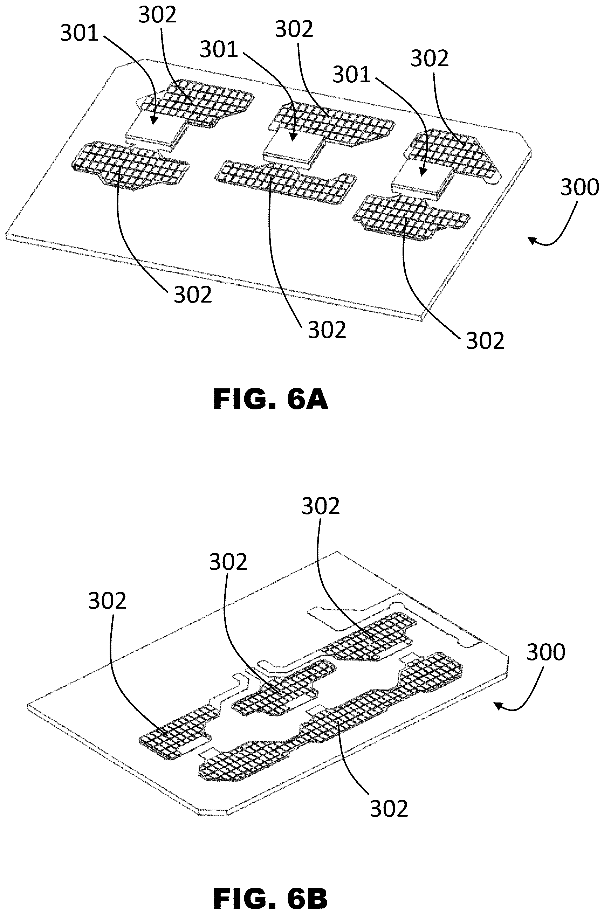

Figure 5 shows in greater detail an embodiment of the flat metal elements 302, in a view in which the electronic board 300 is omitted. Instead, Figures 6A and 6B show the two faces of the electronic board 300 comprising the flat metal elements 302, respectively.

It should be noted that, even if there are three power modules 301, other elements of the electronic board 300 that are required for the operation of the electric motor 100 are omitted for the sake of simplicity in the graphic representation, but they are still to be considered present.

The at least one flat metal element 302 is formed on a first side of the at least one electronic board 300 on which the at least one power module 301 is placed, in Figure 6A. Furthermore, the at least one flat metal element 302 is formed on a second side of the at least one electronic board 300, said second side being opposite the first side, in Figure 6A.

In variants, not shown, in case the at least one flat metal element is technically sufficient for heat dissipation, it can be formed on only one of the first or the second side.

In one preferred embodiment, shown in Figure 5, the at least one flat metal element 302 is made adjacent to the at least one power module 301 both on said first side and on said second side. To improve heat removal on both sides, the at least one electronic board 300 further comprises thermal-bridge contact paths 303 crossing the at least one metal element 302 between the first side and the second side.

In this example, the thermal-bridge contact paths 303 comprise a plurality of columnar metal elements distributed inside a thickness of said at least one electronic board 300. However, other configurations differing in geometry and number of elements may be adopted as thermal-bridge contact paths.

For clarity of exposition, considering denominating the dissipation surface 211 as "first" and the compression-yielding element 401 as "first", it can be said the heat dissipation system further comprises a "second" dissipation surface 212 made of plastic of the housing portion 200, and a "second" compression-yielding element 402 in thermal contact between the at least one flat metal element 302 and the "second" dissipation surface.

It is clear that the denomination "first" and "second" is only made to associate the elements to the "first" and "second" face of the electronic board 300, but this convention could be reversed, as long as there is a part of the dissipation system on at least one, or both, face(s) of the electronic board.

Preferably, the electronic board 300 comprises a plurality of power modules 301, for example three power modules 301 as in the embodiment depicted in Figured 6A. As already described, the heat dissipation system comprises a plurality of flat metal elements 302 which are respectively adjacent (on one side of the board, or also on the other side immediately on the back) to the power modules 301.

Preferably, the plurality of power modules 301 and the plurality of flat metal elements 302 are distributed on the at least one surface, preferably on the front and on the back, of the at least one electronic board 300, to better spread generated heat to be dissipated.

Preferably, the at least one flat metal element 302 is in thermal contact, directly by means of its metal material or by interposition of a further (metal or other, not shown) conductor element, with the at least one power module 301.

In general, heat dissipation occurs in a distributed manner, propagating heat from the power modules 301 of the inverter (heat source) to metal (preferably copper) areas (so called "pads") made in the electronic board 300, that is the various regions of the at least one flat metal element 302 that have the objective to spread, i.e. distribute and/or propagate, heat on the largest possible area.

Moreover, in general, having a plurality of power modules 301 instead of having a single integrated circuit containing inside it all the power components necessary for the inverter allows to localize heat sources in distant regions, i.e. different regions, of the electronic board.

Preferably, three distinct power modules 301 are considered, which allow to make a three-branch inverter.

The power modules 301 are preferably self-powered, high-voltage half-bridge drivers for motors, with integrated protection of the device and system monitoring.

The integrated half-bridge power modules 301 generally allow to operate single-phase or polyphase, PM and BLDC motors, operated by a high-voltage or low-voltage inverter.

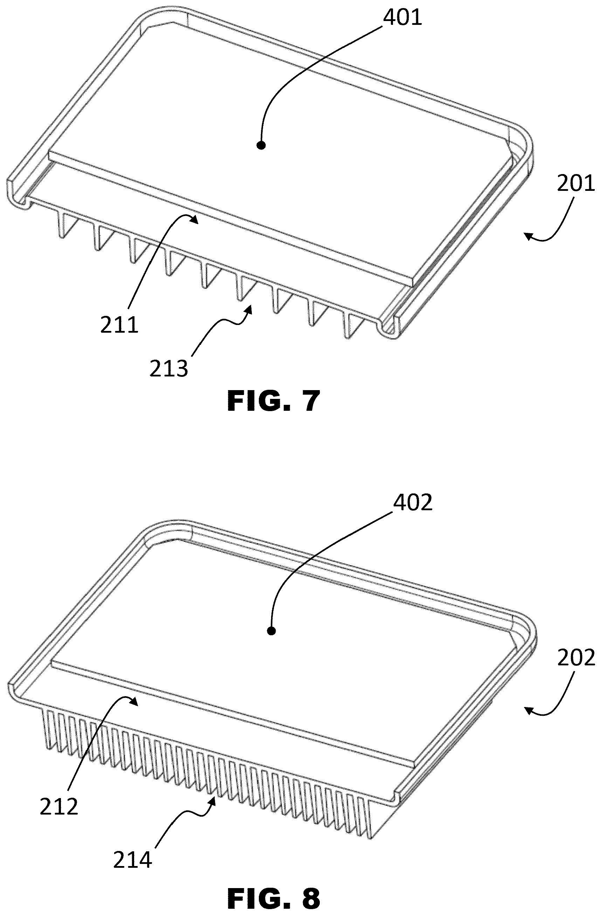

Figure 7 shows an embodiment of the first dissipation surface 211.

The compression-yielding element 401 preferably comprises a thermoplastic elastomer, having the ability to provide thermal contact between the at least one flat metal element 302 and the dissipation surface 211. The thermoplastic elastomer 401 is preferably over-molded on the dissipation surface 211, so as to make a unitary component.

In a variant, the compression-yielding element 401 might comprise silicone, for example it might be a silicone thermal pad, having the ability to provide thermal contact between the at least one flat metal element 302 and the dissipation surface 211.

In another variant, the compression-yielding element 401 might comprise a malleable thermal conductive paste, typically called Gap Filler. Said malleable thermal conductive paste may comprise silicone and may be made as a two-component mixture that is cured at room temperature. In other words, the Gap Filler consists of a soft, thermal conductive elastomer, so as to form the compression-yielding element 401.

Preferably, the dissipation surface 211 of the housing portion 200 externally comprises fins 213 configured to increase a convective thermal exchange with an environment. In alternative embodiments, the dissipation surface 211 might comprise different elements for the convective thermal exchange, such as ribs or studs.

Figure 8 shows an embodiment of the second dissipation surface 212.

The compression-yielding element 402 preferably comprises a thermoplastic elastomer, having the ability to provide thermal contact between the at least one flat metal element 302 and the dissipation surface 212. The thermoplastic elastomer 402 is preferably over-molded on the dissipation surface 212, so as to make a unitary component.

In a variant, the compression-yielding element 402 might comprise silicone, having the ability to provide thermal contact between the at least one flat metal element 302 and the dissipation surface 212.

Preferably, the dissipation surface 212 of the housing portion 200 externally comprises fins 214 configured to increase a convective thermal exchange with an environment. In alternative embodiments, the dissipation surface 212 might comprise different elements for the convective thermal exchange, such as ribs or studs.

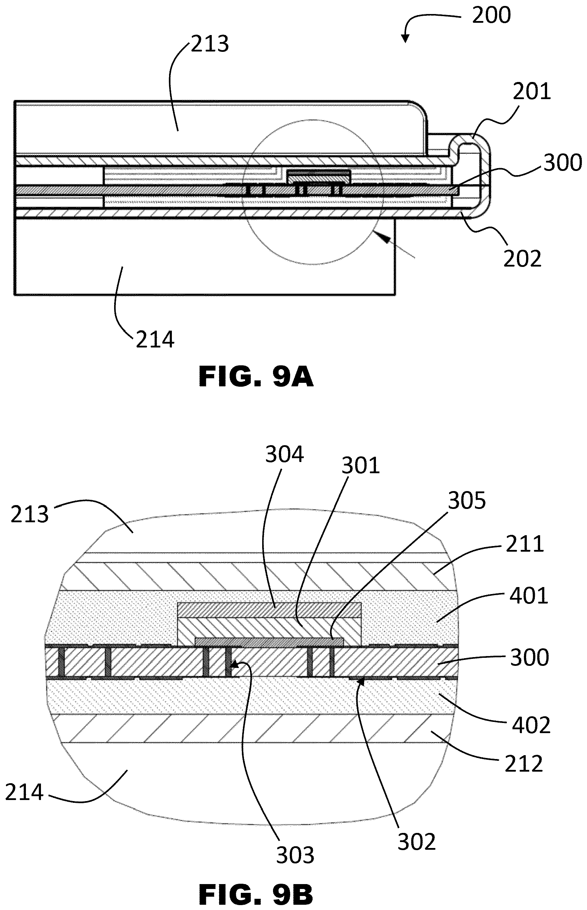

Figure 9A shows a sectional view of the heat dissipation system of Figure 4, whereas Figure 9B shows a magnification of the region highlighted by the circle of Figure 9A.

Also according to what has already been described, the heat dissipation system comprises at least one flat metal element 302 on at least one surface of the at least one electronic board 300, adjacent to the at least one power module 301.

The heat dissipation system further comprises a dissipation surface 211 of the housing portion made of plastic.

The heat dissipation system further comprises a compression-yielding element 401 in thermal contact between the at least one flat metal element 302 and the dissipation surface 211.

The at least one flat metal element 302 also extends on the opposite surface of the at least one electronic board 300, still adjacent to the at least one power module 301 but on the opposite face.

Thus, the heat dissipation system comprises a dissipation surface 212 of the housing portion 200 made of plastic.

The heat dissipation system further comprises a compression-yielding element 402 in thermal contact between the at least one flat metal element 302 and the dissipation surface 212.

In this example, heat dissipation occurs on both sides of the at least one electronic board 300, by means of a replication of the compression-yielding elements 401 and 402 which provide thermal contact between the at least one flat metal element 302 on the two sides of the electronic board 300 and the respective dissipation surfaces 211 and 212.

Preferably, the compression-yielding element 401 or 402 has a first thermal transmittance, whereas the dissipation surface 211 or 212 has a second thermal transmittance. Preferably, the second thermal transmittance is between 70% and 130% of the first thermal transmittance. In other words, the first thermal transmittance and the second thermal transmittance are more or less equal, the possible difference being ±30%. In this way, a substantially uniform transmittance is provided, allowing an adequate conductive thermal exchange for heat dissipation.

Preferably, the compression-yielding element 401 is three-dimensional shaped and is further in thermal contact with a top of the at least one power module 301. This thermal contact may occur directly or, as shown in the embodiment of Figure 9B, by interposition of thermal conductive paste 304. In a variant, not shown, the thermal conductive paste 305 might be directly in contact with the dissipation surface 211.

Moreover, as already described, the at least one flat metal element 302 is preferably in thermal contact, directly by means of its metal material or by interposition of a further conductor element 305 shown herein, with the at least one power module 301.

Preferably, the compression-yielding element 401 or 402 may have low thermal conductivity values, for example 0.2 W/mK, up to high thermal conductivity values, for example 10.0 W/mK and more.

Preferably, the dissipation surface 211 or 212 made of plastic may have low thermal conductivity values, for example 0.2 W/mK, up to high thermal conductivity values, for example 20.0 W/mK and more.

In particular, elimination of in-between air by the contact coupling of the compression-yielding element generates, for equal thermal conductivity values of the dissipation surface, better heat dissipation results that are directly proportional to the conductivity increase.

The appropriate coupling of materials of the compression-yielding element and of the respective dissipation surface, and thus the respective thermal conductivity, may be selected depending on the power delivered by the power modules 301, as a consequence of the heat generated by the use of the electric motor 100, in order to obtain the desired heat dissipation results.

Moreover, the dimensioning of the fins 213 or 214 is made based on the "hot grid" created due to the heat amount generated by the power modules 301 positioned on the electronic board 301, which, by means of the compression-yielding element 401 or 402, is brought onto the dissipation surface 211 or 212 and finally released to the environment.

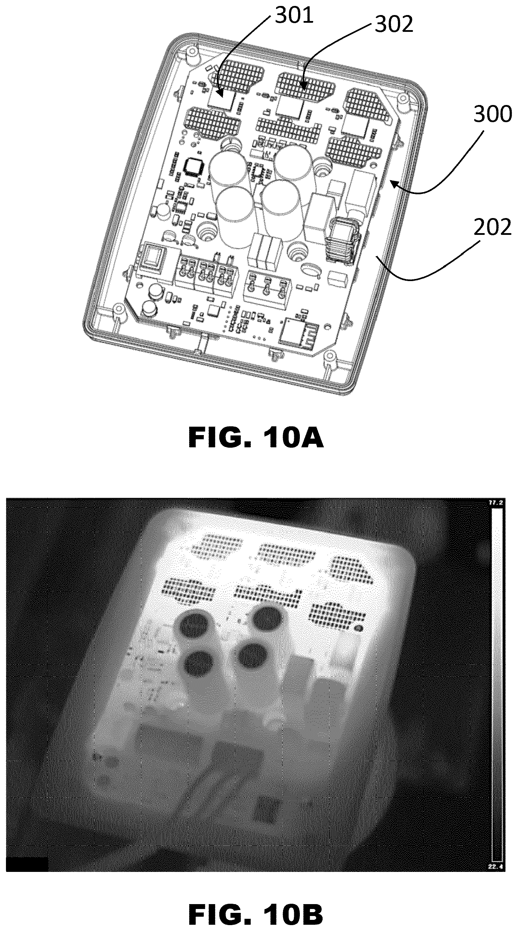

Figure 10A exemplifies an embodiment of an electronic board 300 applied on an element 202, similarly to what has been described for Figure 3.

As it can be observed in the image acquired by means of a thermal camera and shown in Figure 10B, which corresponds to the representation of Figure 10A, the heat distribution on the surface of the electronic board is not only localized close to the power modules 301 but distributes over the entire area occupied by the flat metal elements 302, improving heat dissipation on the dissipation surfaces, as already described.

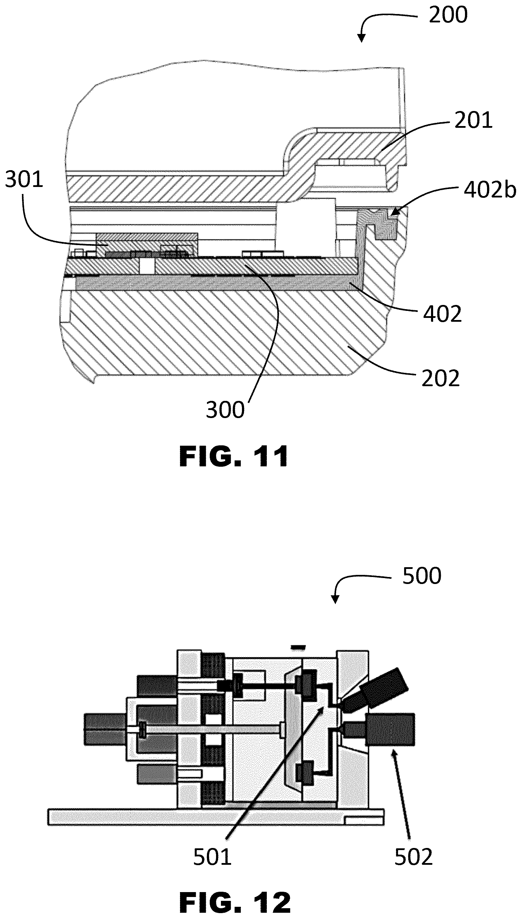

Figure 11 shows a detail of the coupling of a compression-yielding element 402 with a cover 201 of a housing portion 200 including a counterpart 202 of the terminal box 200.

As it can be observed, the compression-yielding element 402 is extended to at least partially surround the at least one electronic board 300, so as to also provide a sealing gasket for the cover 201, in particular by means of the shaped position 402b.

Advantageously, the compression-yielding element 402, in particular in case it is over-molded on the counterpart 202, fulfills at the same time the function of a gasket for the terminal box 200 and also a function of heat dissipation for the electronic board 300.

Figure 12 schematically shows an apparatus 500 for over-molding a thermoplastic elastomer on a plastic surface, so as to form the compression-yielding element over-molded on the dissipation surface.

The apparatus 500 consists in a bi-material molding, with injection 501 of thermoplastic elastomer (for example, standard or thermal conductive rubber) and injection 502 of plastic (for example, standard or thermal conductive plastic).

In this way, it is possible to make a complete dissipating element, out of the mold, such as the elements shown in the already described Figures 7 and 8.

For example, the apparatus 500 allows to make the dissipating parts by means of bi-injection molds of the types: transfer, rotary, index, and sliding split molds.

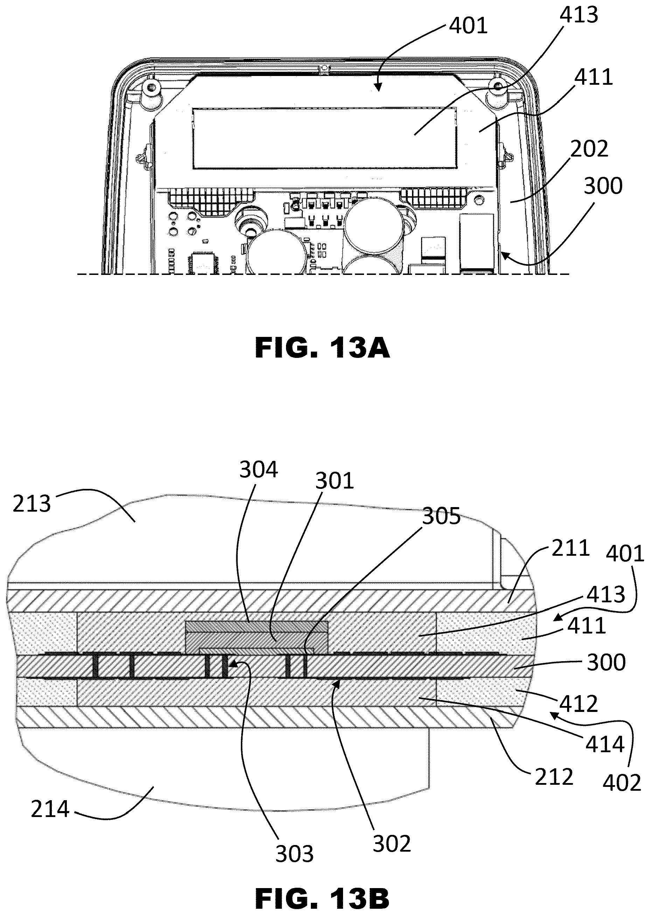

Figures 13A and 13B show a variant of a heat dissipation system, wherein the compression-yielding element 401 or 402 comprises a thermal conductive insert, such as a thermal pad, for example made of silicone.

In the example of Figure 13A, the compression-yielding element 401 comprises a contour portion 411, in particular made of a thermoplastic elastomeric material, and a thermal conductive insert 413 in the central part of the contour portion 411. The contour portion 411, made of standard rubber, allows to remove much of the secondary heat of the board, whereas the thermal conductive mat of the thermal conductive insert 413 is capable of removing the primary heat generated by the power modules 301; both the portion 411 and the insert 413 are in thermal contact with the dissipation surface 211 made of plastic.

In the example of Figure 13B, the sectional view highlights that both the compression-yielding elements 401 and 402 comprise contour portions 411 and 413, respectively, which are preferably made of thermoplastic elastomeric material, and thermal conductive inserts 413 and 414, respectively.

In general, the compression-yielding elements 401 and 402 comprising the thermal conductive inserts 413 and 414 have the function of releasing the heat from the hottest region of the electronic board 100 by means of the silicone inserts 413 and 414, whereas the dissipation of secondary heat of the remaining areas pertains to the rubber of portions 411 and 412.

Preferably, the thermal conductive insert 413 or 414 may have low thermal conductivity values, for example 0.2 W/mK, up to high thermal conductivity values, for example 10.0 W/mK and more.

As already described, a compression-yielding element with thermal conductive insert may be positioned on one of the two sides of the electronic board or on both sides.

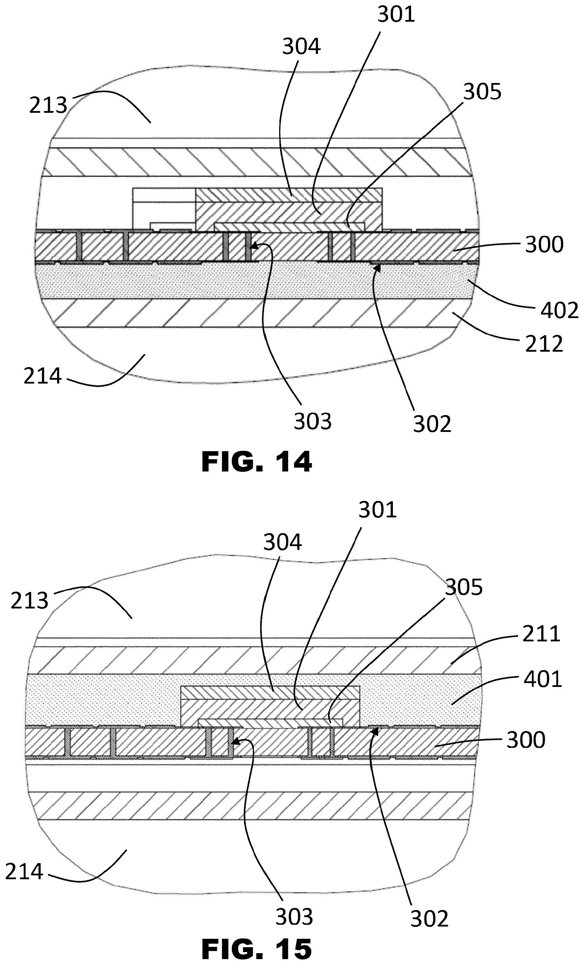

Figure 14 shows a second embodiment of a heat dissipation system.

The heat dissipation system comprises at least one flat metal element 302 on at least one surface of the at least one electronic board 300 adjacent to the at least one power module 301.

The heat dissipation system comprises a dissipation surface 212 made of plastic of the housing portion 200.

The heat dissipation system comprises a compression-yielding element 402 in thermal contact between the at least one flat metal element 302 and the dissipation surface 212.

In the example of this embodiment, compared to the one exemplified in Figure 9B, heat dissipation occurs on only one side of the at least one electronic board 300, by means of a single compression-yielding element 402 which provides thermal contact between the at least one flat metal element 302 and the respective dissipation surface 212.

It should be noted that, in this example, the at least one flat metal element 302 is replicated, for the sake of simplicity in relation to what has already been described, on the two sides of the electronic board 300 but it might be present only on the lower side in contact with the compression-yielding element 402.

Figure 15 shows a third embodiment of a heat dissipation system.

The heat dissipation system comprises at least one flat metal element 302 on at least one surface of the at least one electronic board 300 adjacent to the at least one power module 301.

The heat dissipation system comprises a dissipation surface 211 made of plastic of the housing portion 200.

The heat dissipation system comprises a compression-yielding element 401 in thermal contact between the at least one flat metal element 302 and the dissipation surface 211.

In the example of this embodiment, compared to the one exemplified in Figure 9B, heat dissipation occurs on only one side of the at least one electronic board 300, by means of a single compression-yielding element 401 which provides thermal contact between the at least one flat metal element 302 and the respective dissipation surface 211.

It should be noted that, in this example, the at least one flat metal element 302 is replicated, for the sake of simplicity in relation to what has already been described, on the two sides of the electronic board 300 but it might be present only on the upper side in contact with the compression-yielding element 402.

Considering Figures 9B, 14 and 15 described above, it is appreciated that the heat dissipation system may be configured on both sides of the at least one electronic board 300, by means of a replication of the compression-yielding elements 401 and 402 which provide thermal contact between the at least one flat metal element 302 on the two sides of the electronic board 300 and the respective dissipation surfaces 211 and 212, or on only one of said sides, based on construction needs of the specific housing 200 of the electric motor 100.

Considering the description reported herein, a person skilled in the art can devise further modifications and variants, for the purpose of satisfying specific and particular requirements.

The embodiments described herein are thus to be understood as non-limiting examples of the invention.

## Claims

1. Electric motor with heat dissipation system,
wherein said electric motor (100) comprises:
- an electric motor body (110),
- at least one electronic board (300) for power supply and control of said electric motor (100), said at least one electronic board (300) comprising at least one power module (301),
- a housing portion (200; 201, 202) associated with said electric motor body (110) to contain said at least one electronic board (300),
and wherein said heat dissipation system comprises:
- at least one flat metal element (302) on at least one surface of said at least one electronic board (300) adjacent to said at least one power module (301),
- a dissipation surface (211; 212) of said housing portion (200; 201, 202), said dissipation surface (211, 212) being made of plastic,
- a compression-yielding element (401; 402) in thermal contact between said at least one flat metal element (302) and said dissipation surface (211; 212).

2. Electric motor according to claim 1, wherein said compression-yielding element (401; 402) comprises a thermoplastic elastomer, preferably over-molded on said dissipation surface (211; 212).

3. Electric motor according to claim 1 or 2, wherein said compression-yielding element (401; 402) comprises silicone or at least one thermal conductive insert (413; 414), preferably at least one silicone insert.

4. Electric motor according to any one of claims 1 to 3, wherein said compression-yielding element (401; 402) is three-dimensional shaped and is further in thermal contact with a top of said at least one power module (301) directly or by interposition of thermal conductive paste (304).

5. Electric motor according to any one of claims 1 to 4, wherein said compression-yielding element (402) is extended so as to surround said at least one electronic board (300) at least partially, in order to also provide a sealing gasket (402b) for a cover (201) of said housing portion (201, 202).

6. Electric motor according to any one of claims 1 to 5, wherein said compression-yielding element (401; 402) has a first thermal transmittance, wherein said dissipation surface (211; 212) has a second thermal transmittance between 70% and 130% of said first thermal transmittance.

7. Electric motor according to any one of claims 1 to 6, wherein said at least one flat metal element (302) is formed on a first side of said at least one electronic board (300) whereon said at least one power module (301) is placed, and/or on a second side of said at least one electronic board (300), said second side being opposite said first side.

8. Electric motor according to claim 7, wherein said at least one flat metal element (302) is made adjacent to said at least one power module (301) both on said first side and on said second side, wherein said at least one electronic board (300) further comprises thermal-bridge contact paths (303) crossing said at least one metal element (302) between said first side and said second side.

9. Electric motor according to claim 8, wherein said heat dissipation system further comprises:
- a second dissipation surface (212; 211) of said housing portion (200; 201, 202), said second dissipation surface (212; 211) being made of plastic,
- a second compression-yielding element (402; 401) in thermal contact between said at least one flat metal element (302) and said second dissipation surface (212; 211).

10. Electric motor according to any one of claims 1 to 9, wherein said electronic board (300) comprises a plurality of said power modules (301), and wherein said heat dissipation system comprises a plurality of said flat metal elements (302) adjacent to said power modules (301), respectively.

11. Electric motor according to claim 10, wherein said power modules (301) and said flat metal elements (302) are distributed on said at least one surface of said at least one electronic board (300), to spread heat.

12. Electric motor according to any one of claims 1 to 11, wherein said at least one flat metal element (302) is in thermal contact, directly or by interposition of a further conductor element (305), with said at least one power module (301).

13. Electric motor according to any one of claims 1 to 12, wherein said dissipation surface (211; 212) of said housing portion (200; 201, 202) externally comprises fins (213; 214), ribs, or studs configured to increase a convective thermal exchange with an environment.

14. Electric motor according to any one of claims 1 to 13, wherein said housing portion (200; 201, 202) is connected to said electric motor body (110), in particular being a terminal box (200; 201, 202) for housing said at least one electronic board (300).

15. Electric motor according to any one of claims 1 to 14, further comprising an impeller (12) enclosed in a volute (13), said impeller (12) being connected in rotation to said electric motor (100) to constitute a fluid circulator (10).
